# EUROPEAN PATENT SPECIFICATION

(11) **EP 2 058 073 B1**
(45) Date of publication and mention of the grant of the patent: **07.07.2010**
(21) Application number: 08019527.4
(22) Date of filing: 07.11.2008
(51) Int. Cl.: B23B 51/02

(54) **Drilling tool**
Bohrwerkzeug
Outil de forage

(30) Priority: 08.11.2007 JP 2007291192
(43) Date of publication of application: 13.05.2009
(73) Proprietor: UNION TOOL CO., Tokyo (JP)
(72) Inventor: Hoshi, Yukiyoshi, Tokyo (JP); Tsuzaka, Hideo, Tokyo (JP); Torigoe, Katsuaki, Tokyo (JP)
(74) Representative: Kramer - Barske - Schmidtchen

(56) References cited:
- JP-A- 2003 039 218
- US-A- 3 778 180
- US-B1- 6 652 203

## Description

### TECHNICAL FIELD

The present invention relates to a drilling tool.

### BACKGROUND ART

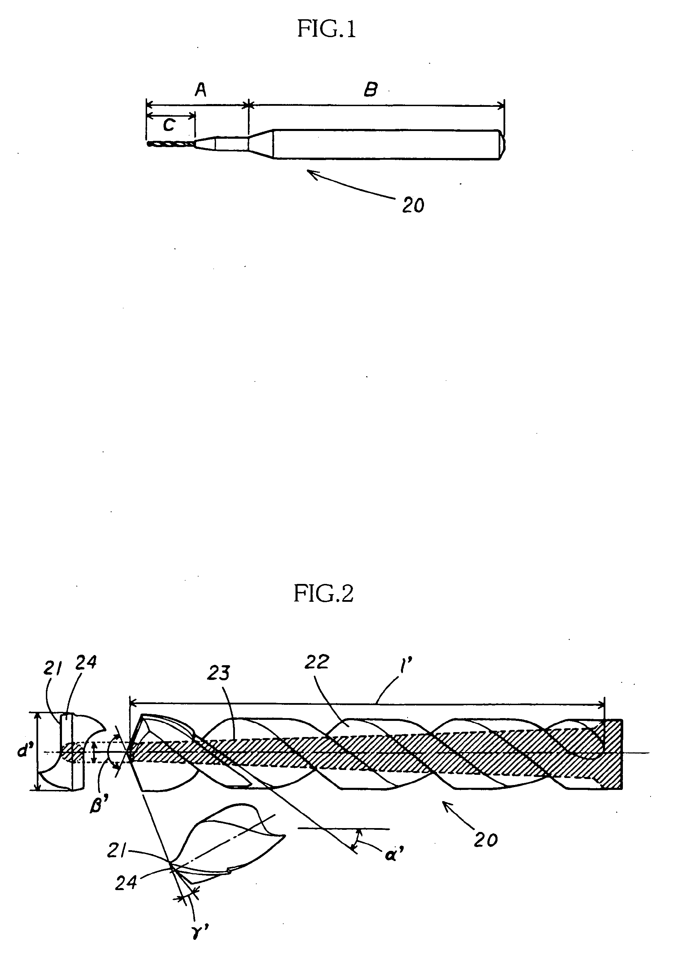

Drills composed of a body A with a lip C and a shank B as illustrated in FIG. 1 are used to drill printed circuit boards (PCB). Specifically, in the lip C, as illustrated in FIG. 2, helical chip-evacuating flutes 22 are formed, from the point to the base, in the outer circumference of the main body 20, and a cutting edge 21 is formed in the intersecting ridge lines of the primary relief 24 provided at the point and the rake surfaces of the chip-evacuating flutes 22. The numerical symbol 23 is the web thickness to which the floor of the chip-evacuating flutes 22 is formed by being connected in a row, d' is the drill diameter, 1' is the chip-evacuating flute length, α' is the helix angle, β' is the point angle, and γ' is the primary relief angle.

Over the years, however, smaller and smaller hole diameters have come to be required in PCBs, and most drilling nowadays involves a diameter of 0.4 mm or less. Most deep hole drilling also involves a hole depth that is 10 times greater than the drill diameter.

Thus, in order to prevent breakage or to improve hole offset, the configuration generally adopted in drills employed for such small-diameter deep hole drilling is to set a lip web thickness that is 30% to 60% of the drill diameter, and to set a web taper of 0.010/mm to 0.040/mm, with the web thickness increasing at a constant degree of tapering along the entire length of the flutes, so that the web thickness gradually increases toward the drill base.

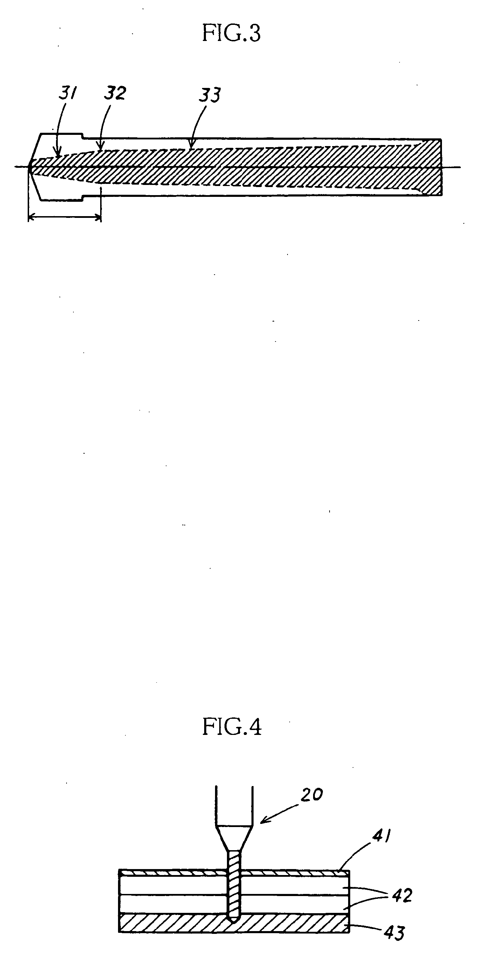

To improve hole offset (hole position accuracy), some have a smaller web thickness to decrease drill bite thrust, and have a first taper region 31 with a first web taper and a second taper region 33 with a second web taper, as illustrated in FIG. 3, allowing the web taper to be modified in two stages. In the drawing, the numerical symbol 32 indicates the point where the web taper changes (portion where the first web taper and the second web taper are connected in a row).

A method that has recently been adopted for cases where the web taper changes in two stages is to make the web thickness of the drill point a smaller one that is 20% to 50% of the drill diameter, make the web taper greater on the point end (about 0.050/mm to 0.150/mm), provide the point where the web taper changes (portion where the first web taper and the second web taper are connected in a row) within about 30% of the flute length from the drill point, and allow the web taper of the chip-evacuating flutes to decrease from the point where the web taper changes toward the drill base end (about 0.003/mm to 0.020/mm), so as to ensure the capacity of the chip-evacuating flutes at the drill base end.

In such cases, however, because the degree of tapering in the web thickness changes significantly near the drill point, chips produced at the drill point are not smoothly evacuated. While it is possible to improve the hole position accuracy, it results in a tendency toward becoming clogged with chips and in the inability to achieve good hole wall roughness.

Rigidity (hole position accuracy) and chip evacuation (hole wall roughness) are thus contradictory factors in drills.

A method often adopted to improve on both of these contradictory factors is to generally increase the helix angle so as to make use of the pump action involved in the rotation of the drill and forcibly push out the chips while preserving rigidity.

However, increasing the helix angle may result in a sharply pointed cutting edge which tends to chip too much, and in decreased drill torsional rigidity which can lead to breakage. Specifically, the conventional helix angle has most often been about 30° to 35°, whereas recently, due to the progress in making smaller diameter drills, there have been more high helical type drills having a helix angle of about 40° to 45°.

Even with a greater helix angle, a greater web thickness and web taper may result in a lower flute capacity and produce a tendency to become clogged with chips and the inability to improve hole wall roughness.

Furthermore, when the helix angle is increased, the chips become stringy, causing the chips to coil around the base end of the flutes on the drill (flute root position) when the copper foil of a PCB 42 or the aluminum of a cover plate 41 is drilled, as illustrated in FIG. 4. The numerical symbol 43 in the figure is a plank.

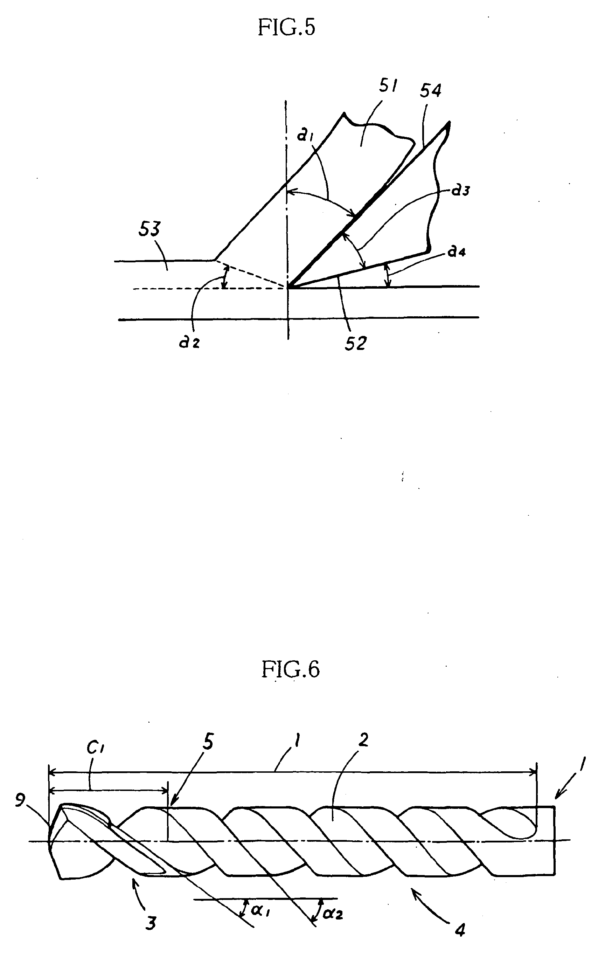

The chips become stringy because the helix angle can be regarded as the rake angle a₁ of the cutting edge on the outer circumference of the drill, as illustrated in FIG. 5, and this cutting edge rake angle a₁ increases when the helix angle is increased, so that the shear angle a₂ of the aluminum or copper chips becomes larger, resulting in longer, thinner chips 51. In the figure, the numerical symbol 52 is the primary relief, 53 is the object being drilled, 54 is the rake surface, a₃ is the lip angle, and a₄ is the primary relief angle.

The coiling of the chips interferes with the evacuation of the chips from the drilled hole, often causing problems such as drill breakage or poor hole position accuracy. That is, the pump action brought about by increasing the helix angle is also a factor contradicting chip evacuation.

Further drilling tools in which one or more helical chip-evacuating flutes are formed are known from US 6,652,203 B1, JP 2003-39 218 A and US 3,778,180.

US 6,652,203 B1 discloses the features according to the preamble of claim 1.

In view of the foregoing, an object of the present invention is to provide a far more practical drilling tool that is both rigid and capable of chip evacuation, can prevent chips from coiling, and is capable of drilling holes having good hole position accuracy and hole wall roughness using a small-diameter drill of 0.4 mm or less.

### DISCLOSURE OF THE INVENTION

The main points of the present invention are described below with reference to the attached drawings.

In a first aspect, the present invention relates to a drilling tool in which one or more helical chip-evacuating flutes 2 are formed, from the tool point to the base, in the outer circumference of a tool main body 1, characterized in that the chip-evacuating flute 2 has a first helical region 3 with a first helix angle α₁ and a second helical region 4 with a second helix angle α₂ greater than the first helix angle α₁, being provided on the tool base side of the first helical region 3, the tool main body 1 is formed so that the web thickness w gradually increases toward the tool base side, and has a first taper region 6 with a first web taper and a second taper region 7 with a second web taper smaller than the first web taper, being provided on the tool base side of the first taper region 6, a portion 5 where the first helical region 3 and the second helical region 4 are connected in a row is located more toward the point end of the tool main body 1, and a portion 8 where the first taper region 6 and the second taper region 7 are connected in a row is located more toward the tool base side than the portion 5 where the first helical region 3 and the second helical region 4 are connected in a row.

In a second aspect, the invention also relates to a drilling tool according to the first aspect, characterized in that the portion 5 where the first helical region 3 and the second helical region 4 are connected in a row is in a location less than 30% of the chip-evacuating flute length 1 from the point end of the tool main body 1.

In a third aspect, the invention furthermore relates to a drilling tool according to the first or second aspect, characterized in that the portion 8 where the first taper region 6 and the second taper region 7 are connected in a row is in a location 30% to 90% of the chip-evacuating flute length 1 from the point of the tool main body 1.

In a fourth aspect, the invention also relates to a drilling tool according to one of the first to third aspect, characterized in that the portion 8 where the first taper region 6 and the second taper region 7 are connected in a row is in a location 50% to 90% of the chip-evacuating flute length 1 from the point of the tool main body 1.

In a fifth aspect, the invention still furthermore relates to a drilling tool according to one of the first to fourth aspect, characterized in that the web thickness w of the tool main body is set to 20% to 60% of the tool diameter d.

In a sixth aspect, the invention also relates to a drilling tool according to one of the first to fifth aspect, characterized in that the first helix angle α₁ is set to 30° to 40°.

In a seventh aspect, the invention also relates to a drilling tool according to one of the first to sixth aspect, characterized in that the second helix angle α₂ is set to an angle 5° to 20° greater than the first helix angle α₁.

In an eighth aspect, the invention also relates to a drilling tool according to one of the first to seventh aspect, characterized in that the first web taper is set to 0.020/mm to 0.100/mm.

In a ninth aspect, the invention also relates to a drilling tool according to one of the first to eighth aspect, characterized in that the second web taper is set to 0.003/mm to 0.020/mm.

In a tenth aspect, the invention also relates to a drilling tool according to one of the first to ninth aspect, characterized in that the tool diameter d is 0.4 mm or less.

Because it is constructed in the manner described above, the present invention results in a far more practical drilling tool that is both rigid and capable of chip evacuation, can prevent chips from coiling, and is capable of drilling holes with good hole position accuracy and hole wall roughness using a small-diameter drill of 0.4 mm or less.

### BRIEF DESCRIPTION OF THE DRAWINGS

FIG. 1 is a side view schematically illustrating a drill for a PCB;
FIG. 2 is an enlarged schematic view of the main parts of a conventional example;
FIG. 3 is a schematic view of a conventional example;
FIG. 4 is a schematic view of machining with a drilling tool;
FIG. 5 is an enlarged schematic view of the machined object;
FIG. 6 is an enlarged schematic side view of the main parts of an embodiment;
FIG. 7 is an enlarged schematic view of the main parts of the embodiment;
FIG. 8 is a table comparing the configuration data of the embodiment and a conventional example;
FIG. 9 is a table of the measured results for hole wall roughness in the embodiment;
FIG. 10 is a table of the measured results for hole wall roughness in a conventional example;
FIG. 11 is a table of the measured results for hole position accuracy in the embodiment; and
FIG. 12 is a table of the measured results for hole position accuracy in the conventional example.

### BEST MODE FOR CARRYING OUT THE INVENTION

A preferred embodiment of the present invention is briefly described below with reference to the diagrams.

The helix angle at the tool point is made smaller, whereby the chips will be made thicker and shorter, not thinner and longer, the chips will be prevented from coiling around the tool main body 1 and, to that extent, drill breakage is prevented and hole position accuracy improved. The helix angle on the tool base end is made bigger, whereby the thick, short chips produced at the tool point can be smoothly evacuated by better pumping action, preventing the holes from being clogged by chips and improving the hole wall roughness.

A second taper region 7 is also provided closer to the tool base end of the first taper region 6, whereby the rigidity of the tool main body 1 can be ensured, flute capacity can be maintained to a certain extent at the base end of the chip-evacuating flutes 2, and chips can be evacuated smoothly in a commensurate manner.

The portion 8 where the first taper region 6 and the second taper region 7 are connected in a row is also at a location 30% to 90% of the length 1 of the chip-evacuating flute 2 from the point of the tool main body, which may, for example, serve as the tool base end in conventional practice, whereby chips can flow smoothly in the chip-evacuating flutes 2 of the tool point, and the hole wall roughness can be improved in that respect as well.

The portion 8 where the first taper region 6 and the second taper region 7 are connected in a row is also located so as to be offset more toward the tool base end than the portion 5 where the first helical region 3 and the second helical region 4 are connected in a row, making it possible to offset the point of change (portion 8 in which a row connection is made) in the web taper and the point of change (portion 5 in which a row connection is made) in the helix angle which impede chip evacuation, without providing a location where chip evacuation will suddenly become worse, so that the hole position accuracy and hole wall roughness can both be improved, without an inevitable decrease in chip evacuation.

### Embodiments

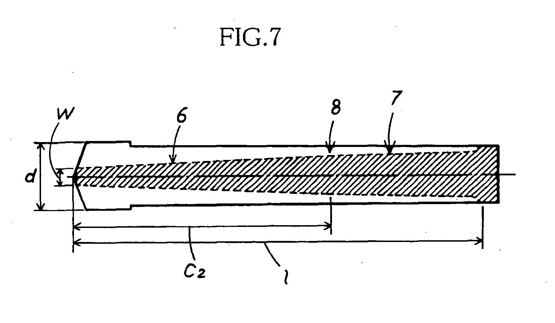

A specific embodiment of the present invention is described below with reference to FIGS. 6 to 12.

The embodiment describes a drilling tool in which one or more helical chip-evacuating flutes 2 are formed, from the tool point to the base, in the outer circumference of a tool main body 1, wherein each of the chip-evacuating flutes 2 has a first helical region 3 with a first helix angle α₁ and a second helical region 4 with a second helix angle α₂ greater than the first helix angle α₁, being provided on the tool base side of the first helical region 3, the tool main body 1 is formed so that the web thickness w gradually increases toward the tool base side, and has a first taper region 6 with a first web taper and a second taper region 7 with a second web taper smaller than the first web taper, being provided on the tool base side of the first taper region 6, the portion 5 where the first helical region 3 and the second helical region 4 are connected in a row is in a location less than 30% of the length 1 of chip-evacuating flutes 2 from the point of the tool main body 1, and the portion 8 where the first taper region 6 and the second taper region 7 are connected in a row is in a location 30% to 90% of the length 1 of chip-evacuating flutes 2 from the point of the tool main body 1.

Specifically, the embodiment describes a drill having a tool diameter d of 0.3 mm and a chip-evacuating flute length 1 of 5.5 mm, which is used to drill PCBs. More specifically, the embodiment describes a modification of the tool illustrated in FIG. 2, wherein the chip-evacuating flutes 2 of the drill have a first helical region 3 and a second helical region 4, and the web thickness w of the tool main body 1 has a first taper region 6 and a second taper region 7. The point angle is set to 130°.

The parts will be described in detail.

The web thickness w of the tool main body 1 is set to 20% to 60% of the tool diameter d. If the value is under 20%, the cutting edge 9 at the tool point will tend to wear out as a result of drilling, and a suitable rigidity will not be achieved, thus resulting in poor hole position accuracy, whereas a value over 60% will not result in a smooth cutting flow at the tool point, and may result in poor hole wall roughness. The value was set to 38% in this embodiment.

The first helix angle α₁ is set to 30° to 40°. This is because setting the helix angle at the cutting edge portion of the point of the drilling tool 40° or less (30° to 40°) will ensure that shorter chips will be produced and that chips can be prevented from coiling around the drill, as chips will coil considerably around the base end (root) of the chip-evacuating flutes 2 when the helix angle is more than 40° in cases where the upper surface of the object being drilled is covered with aluminum or there is an abundance of copper foil on the inner and outer layers or the like of the object being drilled. In this embodiment, the angle was set to 38°.

The second helix angle α₂ is set to an angle that is 5° to 20° greater than the first helix angle α₁. This is because good pumping action will be obtained from the first helical region 3 where the helix angel is made smaller to ensure that shorter chips are produced; the setting is 20° or less because an angle greater by more than 20° may result in a tool with lower torsional rigidity due to the excessively high helical angle. In this embodiment, the angle was set to 45°.

To ensure good evacuation of the chips, the change to the second helix angle α₂ will preferably be done as close as possible to the tool point end, but because a PCB drill is usually reused after the drill point is resharpened (reground), the portion 5 where the first helical region 3 and the second helical region 4 are connected in a row will preferably be in a location 0.3 mm to less than 30% of the chip-evacuating flute length 1 from the tool point, in consideration of the extent of grinding. In this embodiment, the point where the first helix angel α₁ and the second helix angle α₂ change is set so as to be in a location (C₁) 20% of the flue length 1 from the tool point.

The first web taper of the tool main body 1 (web thickness w) is set to 0.020/mm to 0.100/mm, and the second web taper is set to 0.003/mm to 0.020/mm. These web taper settings are suitably established on experimental results or the like. In this embodiment, the first web taper was set to 0.028/mm, and the second web taper was set to 0.007/mm.

The portion 8 where the first taper region 6 and the second taper region 7 are connected in a row is in a location 30% to 90% of the length 1 of the chip-evacuating flute 2 from the point of the tool main body 1. This is because an overlap is possible between the point of change in the helix angle and the point of change in the web taper if the length is less than 30%, and to prevent rapid deterioration in chip evacuation at the point of overlap. A value under 30% will also make it impossible to ensure adequate flute capacity on the point end of the tool, which will tend to result in chip blockage, whereas more than 90% will not only reduce the region (make the region shorter in the axial direction of the tool) having a considerable web thickness in the second taper region 7 and make it difficult to ensure the rigidity of the tool main body 1, but will also result in incorrect positions in which the flutes angle upward, due to improper positioning of the point where the web taper changes when the flutes are machined during the manufacturing process. Because the flute capacity is increased on the tool point end to achieve even better chip evacuation, the location is preferably 50% or greater of the flute length 1 from the point of the tool main body 1. In this embodiment, the point where the first web taper and second web taper change is set so as to be in a location (C₂) 82% of the flute length 1 from the tool point.

Because the embodiment is constructed in the manner described above, the helix angle at the point of the tool is made smaller, whereby the chips can be made thicker and shorter, not thinner and longer, the chips can be prevented from coiling around the tool main body 1, and, to that extent, drill breakage can be prevented and hole position accuracy improved. Also, the helix angle on the tool base end is made bigger, whereby the thick, short chips produced at the tool point can be smoothly evacuated by better pumping action, the holes can be prevented from being clogged by chips, and the hole wall roughness can be improved.

A second taper region 7 is also provided closer to the tool base end than the first taper region 6, whereby the rigidity of the tool main body 1 can be ensured, flute capacity can be maintained to a certain extent at the base end of the chip-evacuating flutes 2, chips can be evacuated smoothly in a commensurate manner.

The portion 8 where the first taper region 6 and the second taper region 7 are connected in a row is also at a location 30% to 90% of the length 1 of the chip-evacuating flute 2 from the point of the tool main body, which may, for example, serve as the tool base end in conventional practice, whereby chips can flow smoothly in the chip-evacuating flutes 2 of the tool point, and the hole wall roughness can be improved in that respect as well.

The portion 8 where the first taper region 6 and the second taper region 7 are connected in a row is also located so as to be offset more toward the tool base end than the portion 5 where the first helical region 3 and the second helical region 4 are connected in a row, making it possible to offset the point of change in the web taper and the point of change in the helix angle which impede chip evacuation, without providing a location where chip evacuation will suddenly become worse, so that the hole position accuracy and hole wall roughness can both be improved, without an inevitable decrease in chip evacuation.

In drills used for PCBs, four-face machined cutting edges having a point angle are generally formed at the point of the tool. The drill flute configuration is formed so that the cutting edge is linear; specifically, viewed in cross section perpendicular to the drill axis, the flute configuration (intersecting ridge lines of the above cross section and flute (rake surface)) has a certain curve, and the grindstone for machining the flutes must be shaped (trued) so as to give that curve. Increasing the helix angle makes it difficult in terms of workability to achieve truing that will result in a grindstone shape capable of forming an ideal cutting edge, and tends to result in a poor cutting edge configuration (cutting edge warpage, bulging, and strain). In recent use, the angle is generally about 45° at most. In this respect, the grindstone can be trued relatively easily in this embodiment because the helix angel at the tool point is set to less than 45°.

When the helix angle at the tool point is greater, the lip angle a₃ formed by the primary relief 52 and the rake surface 54 becomes smaller, as illustrated in FIG. 5, and the cutting edge tends to become chipped. To prevent this, it is necessary to set a smaller primary relief angle a₄, but in that case, the primary relief 52 and the object being drilled 53 tend to come into contact, resulting in substantial wear on the cutting edge as a result of progressive wear in the axial direction of the drill. Thus, in cases where the helix angle is 45° in drills for PCBs, the primary relief angle is commonly set to 10° to 12°. An angle greater than 12° may result in abnormal wear or chipping of the cutting edge during drilling, and at an angle under 10°, the primary relief tends to come into contact with the object being drilled, resulting in greater wear on the cutting edge. In this respect, the helix angle at the point of the tool is set at 30° to 40° in the embodiment, allowing the primary relief angle to be set greater than 12° and, to that extent, increasing the latitude in setting the relief angle of the cutting edge in consideration of the PCB material or machining properties.

As such, this embodiment is both rigid and capable of chip evacuation, can prevent chips from coiling, and is far more practical, being capable of drilling holes having good hole position accuracy and hole wall roughness using a small-diameter drill of 0.4 mm or less.

Experimental examples that substantiate the effects of the present embodiment will not be described.

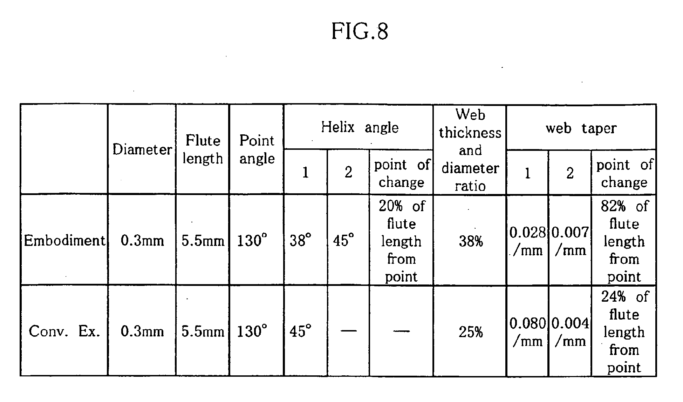

FIG. 8 is a table comparing the configuration data of the embodiment and a conventional example. Here, the embodiment and the conventional example have the same diameter, flute length, and point angle.

An experiment was conducted as shown in FIG. 4, where the specific machining conditions involved the following: PCB (printed circuit board): FR-4/1.6 mm thickness/4 layer Cu; cover plate: 0.2 mm thick aluminum; RPM: 150 krpm; feed: 2.54 m/min; set hit number: 6000.

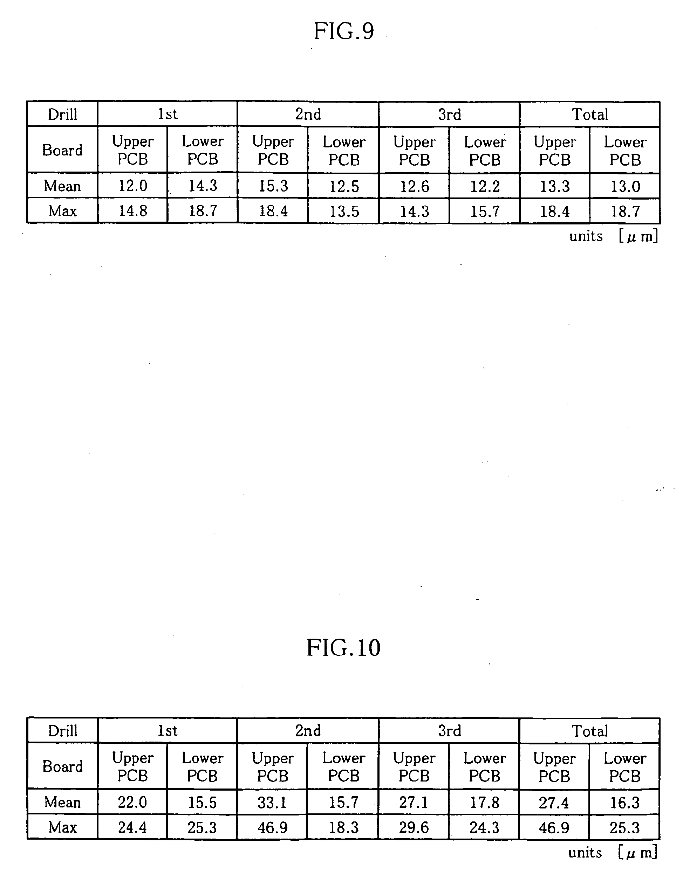

FIG. 9 and FIG. 10 show the measured results for hole wall roughness in the embodiment and conventional example, respectively. A comparison of the two reveals better hole wall roughness in the embodiment than in the conventional example. This was evaluated through copper electroplating of drilled PCBs, molding of the PCBs at the measurement locations by using resin scraps, and grinding until it was possible to observe a longitudinal cross section of the holes at an evaluation hole diameter of around 50%. Hole wall roughness is generally observed to be considerable at 45° relative to the mesh direction of the glass cloth used as the insulating layer in PCB. Therefore, a cross section was selected and observed at 45° during the evaluation. The areas of maximum roughness were measured in the five holes around the last hit number (6,000 hits) in two superposed upper and lower drilled PCBs. The distance from the inner wall surface to the farthest point of roughness was measured. The total mean shown is the mean of the mean values for three, and the maximum value is the greatest of the maximum of the three.

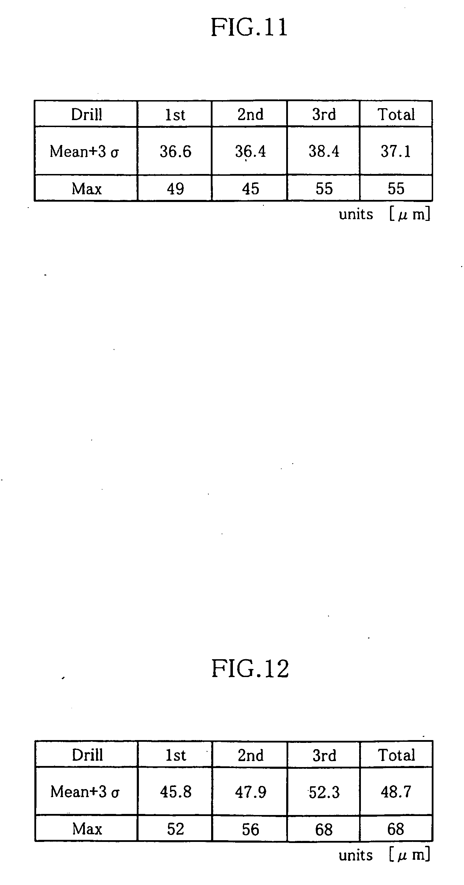

FIGS. 11 and 12 show the measured results for hole position accuracy in the embodiment and conventional example, respectively. Comparison of the two revealed better hole position accuracy in the embodiment than in the conventional example. Hole offset is generally greater on the reverse side of the bottom PCB of the two superposed, drilled PCBs. Hole position accuracy is generally determined by measuring the set hit number in all holes on the reverse side of the substrate using an AOI measuring device. The measured value is the extent of deviation from the target coordinates indicated by NC. The measured results were adjusted by a center of gravity method in order to correct for deviation in the distribution due to disturbances in drill positioning accuracy or the like. The "mean + 3σ (σ = standard deviation)" was used as evaluation data because hole position accuracy is generally the maximum deviation from target coordinates in the set hit number and because the hole position accuracy distribution is generally a normal distribution. The total "mean + 3σ" shown is the mean of the "mean + 3σ" for three, and the maximum value is the greatest of the maximum of the three.

Holes were drilled in PCB in three each of the embodiment and conventional example, at which time the samples were checked to see whether chips had coiled around the drills. Coiling was found in all three samples in the conventional example but not in any of the samples in the embodiment.

It could thus be confirmed that the embodiment had both better wall hole roughness and better hole position accuracy, which are contradictory factors, using a small diameter drill.

It was also confirmed that the structure of the embodiment was suitable for small-diameter drills, particularly drills having a tool diameter of 0.4 mm or less.

## Claims

1. A drilling tool in which one or more helical chip-evacuating flutes (2) are formed, from the tool point to the base, in the outer circumference of a tool main body (1), wherein
the chip-evacuating flute (2) has a first helical region (3) with a first helix angle α₁ and a second helical region (4) with a second helix angle α₂
**characterized in that:**
the second helix angle α₂ is greater than the first helix angle α₁, being provided on the tool base side of the first helical region (3);
the tool main body (1) is formed so that the web thickness w gradually increases toward the tool base side, and has a first taper region (6) with a first web taper and a second taper region (7) with a second web taper smaller than the first web taper, being provided on the tool base side of the first taper region (6);
a portion (5) where the first helical region (3) and the second helical region (4) are connected in a row is located more toward the point end of the tool main body (1); and
a portion (8) where the first taper region (6) and the second taper region (7) are connected in a row is located more toward the tool base side than the portion (5) where the first helical region (3) and the second helical region (4) are connected in a row.

2. The drilling tool according to claim 1, **characterized in that** the portion (5) where the first helical region (3) and the second helical region (4) are connected in a row is in a location less than 30% of the chip-evacuating flute length (1) from the point end of the tool main body (1).

3. The drilling tool according to claim 1 or 2, **characterized in that** the portion (8) where the first taper region (6) and the second taper region (7) are connected in a row is in a location 30% to 90% of the chip-evacuating flute length (1) from the point end of the tool main body (1).

4. The drilling tool according to one of claims 1 to 3, **characterized in that** the portion (8) where the first taper region (6) and the second taper region (7) are connected in a row is in a location 50% to 90% of the chip-evacuating flute (1) from the point end of the tool main body (1).

5. The drilling tool according to one of claims 1 to 4, **characterized in that** the web thickness w of the tool main body is set to 20% to 60% of the tool diameter d.

6. The drilling tool according to one of claims 1 to 5, **characterized in that** the first helix angle α₁ is set to 30° to 40°.

7. The drilling tool according to one of claims 1 to 6, **characterized in that** the second helix angle α₂ is set to an angle 5° to 20° greater than the first helix angle α₁.

8. The drilling tool according to one of claims 1 to 7, **characterized in that** the first web taper is set to 0.020/mm to 0.100/mm.

9. The drilling tool according to one of claims 1 to 8, **characterized in that** the second web taper is set to 0.003/mm to 0.020/mm.

10. The drilling tool according to one of claims 1 to 9, **characterized in that** the tool diameter d is 0.4 mm or less.

## Patentansprüche

1. Bohrwerkzeug, in dem wenigstens eine spiralförmige späneabführende Nut (2) von der Werkzeugspitze zu der Basis in dem äußeren Umfang eines Werkzeughauptkörpers (1) ausgebildet ist, in dem
die späneabführende Nut (2) einen ersten spiralförmigen Bereich (3) mit einem ersten Steigungswinkel α₁ und einen zweiten spiralförmigen Bereich (4) mit einem zweiten Steigungswinkel α₂ aufweist,
**dadurch gekennzeichnet, dass**
der zweite Steigungswinkel α₂ größer ist als der erste Steigungswinkel α₁, der auf der Seite der Werkzeugbasis des ersten spiralförmigen Bereichs (3) vorgesehen ist,
der Werkzeughauptkörper (1) so ausgebildet ist, dass sich die Stegdicke w allmählich in Richtung der Seite der Werkzeugbasis vergrößert und einen ersten konischen Bereich (6) mit einer ersten Stegkonizität und einen zweiten konischen Bereich (7) mit einer zweiten Stegkonizität aufweist, die kleiner ist als die erste Stegkonizität, die auf der Seite der Werkzeugbasis des ersten konischen Bereichs (6) vorgesehen ist,
ein Bereich (5), in dem der erste spiralförmige Bereich (3) und der zweite spiralförmige Bereich (4) hintereinander verbunden sind, sich mehr in Richtung der Endspitze des Werkzeughauptkörpers (1) befindet, und
ein Bereich (8), in dem der erste konische Bereich (6) und der zweite konische Bereich (7) hintereinander verbunden sind, sich mehr in Richtung der Seite der Werkzeugbasis befindet als der Bereich (5), in dem der erste spiralförmige Bereich (3) und der zweite spiralförmige Bereich (4) hintereinander verbunden sind.

2. Bohrwerkzeug nach Anspruch 1, **dadurch gekennzeichnet, dass** der Bereich (5), in dem der erste spiralförmige Bereich (3) und der zweite spiralförmige Bereich (4) hintereinander verbunden sind, sich an einer Stelle kleiner 30% der späneabführenden Nutlänge (1) von der Endspitze des Werkzeughauptkörpers (1) befindet.

3. Bohrwerkzeug nach Anspruch 1 oder 2, **dadurch gekennzeichnet, dass** der Bereich (8), in dem der erste konische Bereich (6) und der zweite konische Bereich (7) hintereinander verbunden sind, sich an einer Stelle zwischen 30% und 90% der späneabführenden Nutlänge (1) von der Endspitze des Werkzeughauptkörpers (1) befindet.

4. Bohrwerkzeug nach einem der Ansprüche 1 bis 3, **dadurch gekennzeichnet, dass** der Bereich (8), in dem der erste konische Bereich (6) und der zweite konische Bereich (7) hintereinander verbunden sind, sich an einer Stelle zwischen 50% und 90% der späneabführenden Nut (1) von der Endspitze des Werkzeughauptkörpers (1) befindet.

5. Bohrwerkzeug nach einem der Ansprüche 1 bis 4, **dadurch gekennzeichnet, dass** die Stegdicke w des Werkzeughauptkörpers auf 20% bis 60% des Werkzeugdurchmessers d festgesetzt ist.

6. Bohrwerkzeug nach einem der Ansprüche 1 bis 5, **dadurch gekennzeichnet, dass** der erste Steigungswinkel α₁ auf 30° bis 40° festgesetzt ist.

7. Bohrwerkzeug nach einem der Ansprüche 1 bis 6, **dadurch gekennzeichnet, dass** der zweite Steigungswinkel α₂ auf einen Winkel festgesetzt ist, der 5° bis 20° größer als der erste Steigungswinkel α₁ ist.

8. Bohrwerkzeug nach einem der Ansprüche 1 bis 7, **dadurch gekennzeichnet, dass** die erste Stegkonizität auf 0,020/mm bis 0,100/mm festgesetzt ist.

9. Bohrwerkzeug nach einem der Ansprüche 1 bis 8, **dadurch gekennzeichnet, dass** die zweite Stegkonizität auf 0,003/mm bis 0,020/mm festgesetzt ist.

10. Bohrwerkzeug nach einem der Ansprüche 1 bis 9, **dadurch gekennzeichnet, dass** der Werkzeugdurchmesser d 0,4 mm oder weniger aufweist.

## Revendications

1. Outil de forage dans lequel sont formées une ou plusieurs cannelures hélicoïdales d'évacuation de copeaux (2), de la pointe de l'outil à la base, dans la circonférence externe d'un corps principal d'outil (1), dans lequel :
la cannelure d'évacuation de copeaux (2) a une première région hélicoïdale (3) avec un premier angle d'hélice α₁ et une seconde région hélicoïdale (4) avec un second angle d'hélice α₂, **caractérisé en ce que** le second angle d'hélice α₂ est supérieur au premier angle d'hélice α₁, qui est ménagé sur le côté de base de l'outil de la première région hélicoïdale (3) ;
le corps principal d'outil (1) est formé de sorte que l'épaisseur w de l'âme augmente graduellement vers le côté de base de l'outil et a une première région conique (6) avec une première conicité d'âme et une seconde région conique (7) avec une seconde conicité d'âme plus petite, qui est ménagée sur le côté de base de l'outil de la première région conique (6) ;
une portion (5) où la première région hélicoïdale (3) et la seconde région hélicoïdale (4) sont raccordées en ligne est située plus vers l'extrémité de pointe du corps principal d'outil (1) ; et
une portion (8) où la première région conique (6) et la seconde région conique (7) sont raccordées en ligne est située plus vers le côté de base de l'outil que la portion (5) où la première région hélicoïdale (3) et la seconde région hélicoïdale (4) sont raccordées en ligne.

2. Outil de forage selon la revendication 1, **caractérisé en ce que** la portion (5) où la première région hélicoïdale (3) et la seconde région hélicoïdale (4) sont raccordées en ligne est située dans un emplacement inférieur à 30 % de la longueur de la cannelure d'évacuation de copeaux (1) de l'extrémité de pointe du corps principal de l'outil.

3. Outil de forage selon la revendication 1 ou 2, **caractérisé en ce que** la portion (8) où la première région conique (6) et la seconde région conique (7) sont raccordées en ligne est située dans un emplacement correspondant à 30 % à 90 % de la longueur de la cannelure d'évacuation de copeaux (1) de l'extrémité de pointe du corps principal d'outil (1).

4. Outil de forage selon l'une quelconque des revendications 1 à 3, **caractérisé en ce que** la portion (8) où la première région conique (6) et la seconde région conique (7) sont raccordées en ligne se situe dans un emplacement correspondant à 50 % à 90 % de la cannelure d'évacuation de copeaux (1) de l'extrémité de pointe du corps principal d'outil (1).

5. Outil de forage selon l'une quelconque des revendications 1 à 4, **caractérisé en ce que** l'épaisseur w de l'âme du corps principal de l'outil est réglée sur 20 % à 60 % du diamètre d de l'outil.

6. Outil de forage selon l'une quelconque des revendications 1 à 5, **caractérisé en ce que** le premier angle d'hélice α₁ est réglé entre 30 ° et 40 °.

7. Outil de forage selon l'une quelconque des revendications 1 à 6, **caractérisé en ce que** le second angle d'hélice α₂ est réglé sur un angle de 5 ° à 20 ° de plus que le premier angle d'hélice α₁.

8. Outil de forage selon l'une quelconque des revendications 1 à 7, **caractérisé en ce que** la première conicité d'âme est réglée sur 0,020/mm à 0, 100/mm.

9. Outil de forage selon l'une quelconque des revendications 1 à 8, **caractérisé en ce que** la seconde conicité d'âme est réglée sur 0,003/mm à 0, 020/mm.

10. Outil de forage selon l'une quelconque des revendications 1 à 9, **caractérisé en ce que** le diamètre d de l'outil est de 0,4 mm ou moins.
